# EUROPEAN PATENT SPECIFICATION

(11) **EP 1 271 783 B1**
(45) Date of publication and mention of the grant of the patent: **31.07.2013**
(21) Application number: 02013243.7
(22) Date of filing: 17.06.2002
(51) Int. Cl.: H03K 19/177

(54) **FPGA with a simplified interface between the program memory and the programmable logic blocks**
FPGA mit vereinfachtem Interface zwischen dem Programmspeicher und den programmierbaren logischen Blöcken
FPGA avec une interface simplifiée entre la mémoire de programme et les blocs logiques programmables

(30) Priority: 29.06.2001 IN DE07292001
(43) Date of publication of application: 02.01.2003
(73) Proprietor: Sicronic Remote KG, LLC, Wilmington, DE 19801 (US)
(72) Inventor: Bal, Ankur, Ghaziabad 201002 (IN)
(74) Representative: Kazi, Ilya

(56) References cited:
- GB-A- 2 351 824
- US-A- 5 811 985
- US-A- 6 144 220
- US-B1- 6 191 998
- BURSKY D: "EFFICIENT RAM-BASED FPGAS EASE SYSTEM DESIGN" ELECTRONIC DESIGN, PENTON PUBLISHING, CLEVELAND, OH, US, vol. 44, no. 2, 22 January 1996 (1996-01-22), pages 53-54,58,60,6, XP000580106 ISSN: 0013-4872

## Description

This invention relates to a system for simplifying the programmable memory to logic interface in FPGA.

An FPGA is a semi custom device based on an array of generic cells or logic blocks, each having a programmable function, surrounded by a programmable interconnect network. Inclusion of RAM blocks in the FPGA architecture saves lot of valuable logic & routing resources. Memory intensive applications are accommodated within an FPGA with embedded RAM blocks. Also, many wide input output functions are absorbed into the RAM blocks, thus saving logic and interconnect resources. These RAM blocks are generally evenly distributed on the FPGA chip. An interconnect system is provided for the RAM to interface with other logic resources on chip. In the prior art of patent number 5933023 of Xilinx, routing lines which access the logic blocks also access address, data, and control lines in the RAM blocks. This results in great routing flexibility between the RAM and other logic blocks, but at the same time offers a very complex model to the software tool. A plethora of constraints in terms of intra bus net slack, general routing asymmetry, routing congestion and many others come into picture.

The patent GB2351824 discloses a high-performance programmable logic architecture which has embedded memory arranged at peripheries or edges of the integrated circuit. This enhances performance of the programmable logic integrated circuit by shortening the lengths of the programmable interconnect. The memory blocks are organized in rows along the top and bottom edges of the integrated circuit. The logic elements can be be directly programmable routed and connected to driver blocks of the logic blocks in adjacent rows and columns. This permits fast interconnection of signals without using the global programmable interconnect resources. Using similar direct programmable interconnections the logic blocks can directly programmable connect to the memory blocks without using the global programmable interconnect resources.

The object of this invention is to obviate the above drawback.

To achieve the said objectives, this invention provides a field-programmable array as defined in the claims.

The invention will now be described with reference to the accompanying drawings.

Figure 1 shows FPGA chip with embedded memory RAM according to prior art.

Figure 2 delineates interconnects scheme of the prior art for a rudimentary single port RAM.

Figure 3 shows a simple single port memory with a plurality of multiplexers and de-multiplexers at its input and output pins respectively.

Figure 4 shows devoted bus based routing for clubbing data and address lines in order to combine the RAM blocks to implement larger memories according to this invention.

Figure 5 shows a scheme for eliminating the internal registers of the embedded memory thereby saving significant area.

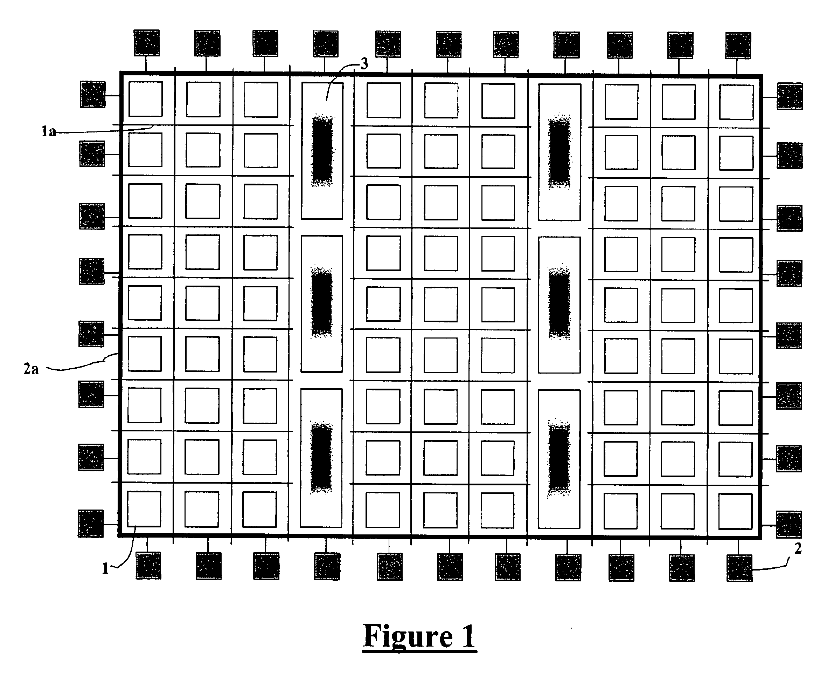

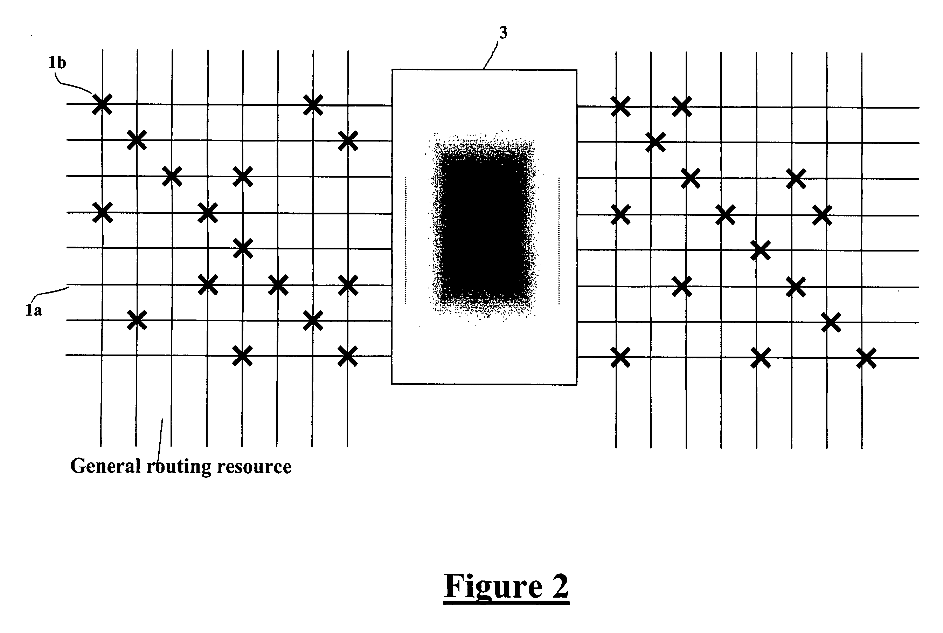

Figure 1 shows an FPGA chip with embedded memory (RAM) in the prior art. Item [1] is a generic programmable logic block (PLB), [3] is the RAM, [1a] is the general routing fabric, [2a] are the Input-Output (IO) routing resources and [2] are the IO pads. Figure 2 delineates the interconnect scheme of the prior art for a rudimentary single port RAM. Configurable switches [3] interface the memory to the routing interconnects in the routing channel. These routing lines can also be accessed by logic blocks or IO pads through the routing channel. Thus, a lot of flexibility is provided. But many constraints are introduced and the software for routing such architectures becomes very complex as the memory (RAM) blocks in the FPGA chip are augmented.

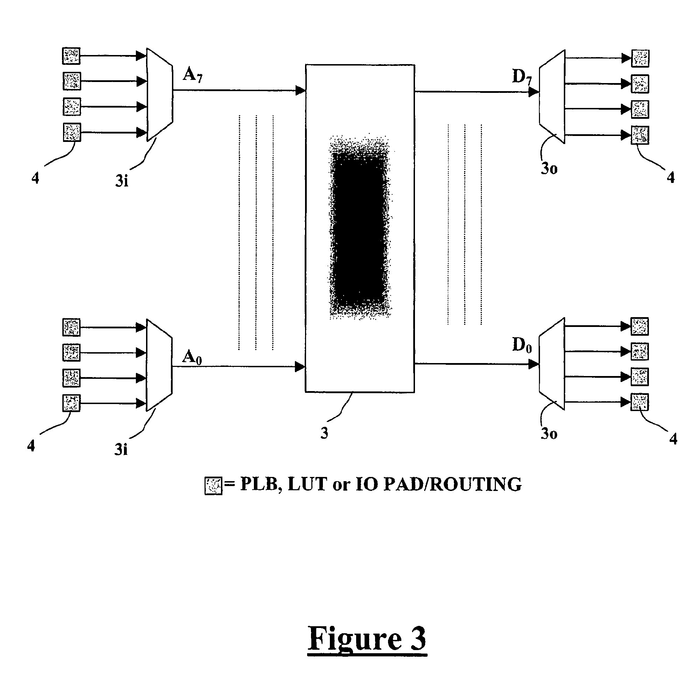

The basic embodiment of figure 3 aims to bring forth the advantages of the present invention. Referring to figure 3, a simple single port memory is shown with a plurality of multiplexers [3i] and de-multiplexers [3o] at its input and output pins respectively. It is apparent that the RAM has eight address inputs and eight data outputs. The inputs to the multiplexers [3i] are outputs from various PLB (or even the same PLB) or from IO pads/routing. Similarly, outputs from de-multiplexers [3o] are being fed to PLB inputs or IO resources. The multiplexer [3i] & de-multiplexer [3o] will be configured during initial configuration of the device. In most cases all [3i] multiplexers and [3o] de-multiplexers can share their respective configuration bits, thus reducing the configuration latch count. The direct interconnects to/from IO routing at the device periphery may be provided to facilitate signals from a range of IO pads rather than a single pad.

Therefore, by using programmable direct interconnects for memory interface, many advantages are in the offering. Some of the major advantages are given below.

It is to be noted that PLBs which interact with the RAM do so only through programmable tappings to/from their inputs or outputs. Their connectivity to the general-purpose routing fabric is not altered in any way. The basic idea of extending direct interconnects from PLBs or IOs is to spare the general purpose routing from the burden of RAM interconnects. It is very obvious that the memory block will network signals to/from either a sub-circuit or an IO resource. The invention attempts to eliminate any routing that might be used to convey signals between sub-circuits/IOs and the memory. The same arguments hold valid for control signals to/from the memory. Although some limitations are inherent in terms of flexibility when direct interconnects are used for memory interface, but the architecture becomes software friendly.

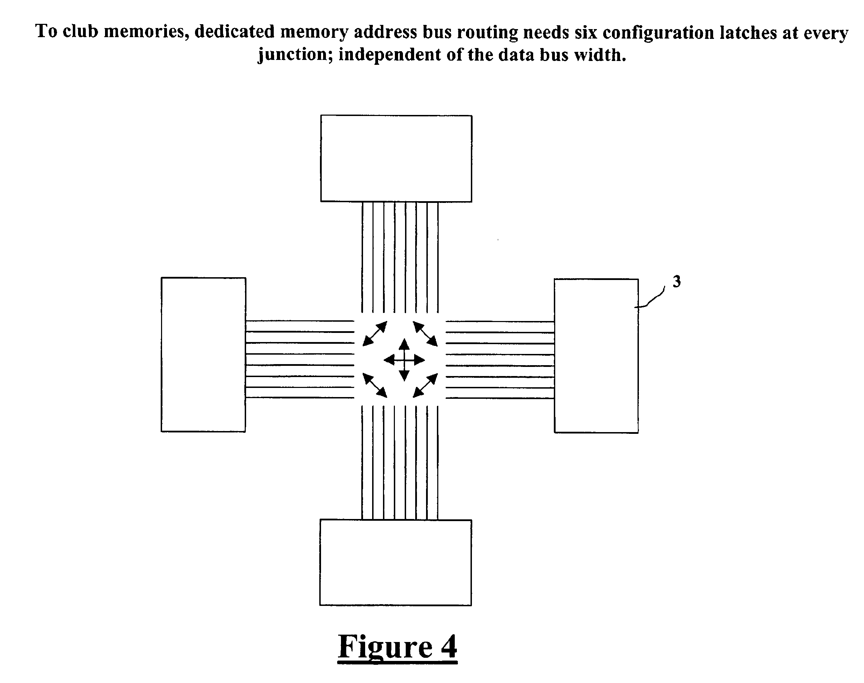

Another aspect of the invention is to provide for devoted bus based routing for clubbing data and address lines in order to combine the RAM blocks to implement larger memories (figure 4). This dedicated routing extends between memory address ports or data ports that might be combined for large memory emulation. As the routing is bus based, configuration latch count is reduced because a bus is routed as a whole against a net-to-net route.

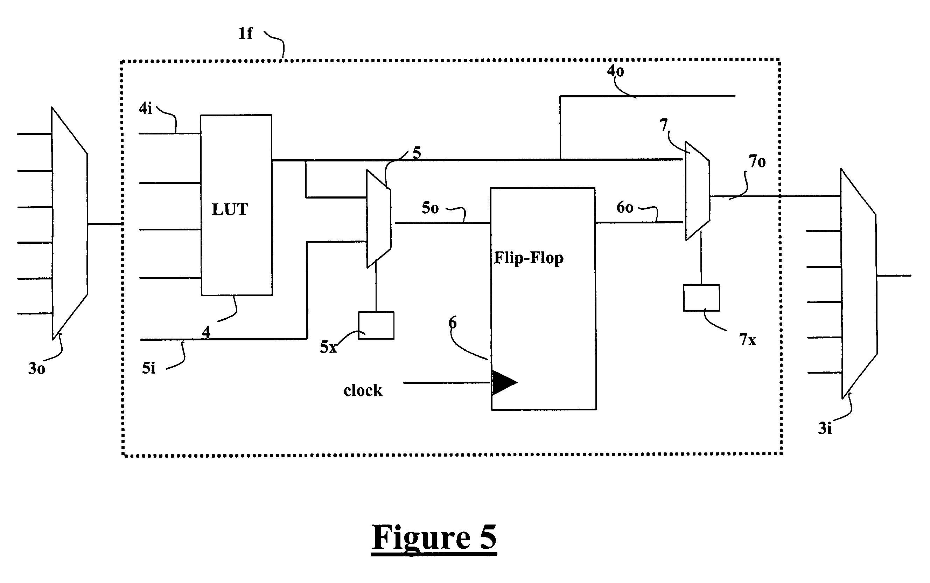

In figure 5, the multiplexer[3i] sourcing a memory input is shown connected to the PLB output via a DI[7o] (Direct Interconnect) . The memory block can be used in both asynchronous and synchronous mode. The asynchronous mode comes into picture when the memory block is used to implement combinatorial logic. In this mode, the memory block receives unregistered output[4o] of the LUT via multiplexer[7]. The memory output is directed through multiplexer [3o] to the PLB input [4i] that is an LUT input. The control line of the multiplexers is suitably configured by the configuration latches[5x & 7x].

In the synchronous mode, the memory block is used as a RAM. In this mode, the registered output [60] of the LUT is connected to the Memory input via the multiplexers [7] & [3i]. The control line of the multiplexer is suitably configured by the configuration latch[7x] to include the flip-flop output. Another possibility is to connect the FF input to [5i] via multiplexer [5] . This enables the memory input signal to bypass the LUT output and approach the FF from general purpose routing. The flip-flop associated with each LUT obviates the need of internal memory registers present at the input of a conventional memory block. The clock of the flip-flop initiates the read/ write operation of the memory.

Similarly, the output registers of the memory become redundant as multiplexer [3o] can drive a PLB input [5i]. Output of multiplexer[3o] is directed to FF[6] via multiplexer [5]. Thus, we can save memory registers internal to the memory in an FPGA with memory blocks.

It is also apparent that if the Flip-Flop is used as a memory input/output register, the LUT can be used to perform independently.

The major advantages of the present invention are listed hereinbelow.

The architecture is simplified, as switch pattern interfaces between general routing and the memories are eliminated.

The input/output registers internal to a memory are eliminated.

The symmetric properties of the general purpose routing are preserved.

The memory routing is independent of PLB routing architecture and is bus based. This results in a symmetrical PLB routing architecture. Configuration latch count in intra-memory routing is reduced, with the additional advantage of improved flexibility in tying up memories.

There is no slack among nets comprising the address/data bus. Negligible slack that might be introduced while clubbing memories can be easily controlled.

The even distribution of memory resources in the FPGA is facilitated, without increasing complexity.

The invention greatly reduces the formidable task of routing memories to PLBs for the Place & Route tool; algorithms and time complexity of the tool are simplified.

## Claims

1. A field-programmable gate array, having a simplified interface between embedded memory (3) and programmable logic blocks (1) and input-output resources (2), the field-programmable gate array including:
an array of programmable logic blocks (1);
a plurality of input-output resources (2);
at least one embedded memory (3) having input pins and output pins and a plurality of address lines, data lines and control lines connected thereto;
a general purpose routing architecture (1a) comprising routing lines adapted to be accessed by the programmable logic blocks and the input-output resources; wherein
said interface is arranged for connecting said programmable logic blocks and input-output resources to the embedded memory using multiple dedicated direct interconnects, said multiple direct interconnects being distinct from and not part of the general purpose routing architecture (4, 3i, 3o, A₀, A₇, D₀, D₇)
whereby the general purpose routing architecture (1a) is isolated from the address lines, data lines and control lines of the at least one embedded memory (3);
wherein the direct interconnects are connected to the input pins of the embedded memory (3) and are tapped from outputs of programmable logic blocks (1) in vicinity of the embedded memory (3) and the output pins of the embedded memory (3) are directly connected to inputs of programmable logic blocks (1) in the neighbourhood of the embedded memory (3); **characterized in that**
said programmable logic blocks (1) comprise memory registers or flip flops which are configured for latching signals to be sent to or received from the embedded memory (3) through said direct interconnects, whereby registers internal to said embedded memory (3) are eliminated, thereby saving significant chip area.

2. The field-programmable gate array as claimed in claim 1 wherein said embedded memory has a plurality of multiplexers and de-multiplexers at its input and output pins respectively.

3. The field-programmable gate array as claimed in claim 2 wherein,
the inputs to the multiplexer are outputs from various of said programmable logic blocks or even the same programmable logic block or from the input-output resources;
the outputs from the de-multiplexer are connected to programmable logic blocks inputs or input-output resources.

4. The field-programmable gate array as claimed in any one of the preceding claims, wherein the programmable logic blocks interact with said embedded memory only through programmable tappings to/from their inputs and outputs.

5. The field-programmable gate array as claimed in any one of the preceding claims, further comprising devoted bus based routing for clubbing the data and address lines, in order to combine a plurality of embedded memories into larger memories.

6. The field-programmable gate array as claimed in any one of the preceding claims wherein said memory registers or flip-flops of said programmable logic blocks can also receive inputs from the general purpose routing architecture.

7. The field-programmable gate array as claimed in any one of the preceding Claims, wherein said programmable logic blocks comprise each a LUT, wherein the LUT and the memory register of each programmable logic block can also be used for other functionality independent of the interfacing to the embedded memory.

8. The field-programmable gate array as claimed in claim 6, wherein said memory registers or flip-flops are selectively bypassed for the case when unregistered memory inputs and outputs are required.

9. The field-programmable gate array as claimed in any one of the preceding claims, wherein said embedded memory is either ROM or RAM.

10. The field-programmable gate array as claimed in any one of the preceding claims, wherein connectivity of said programmable logic blocks and input-output resources with the general purpose routing architecture coexists with said interface and with said embedded memory.

## Patentansprüche

1. Feldprogrammierbare Gatteranordnung mit einer vereinfachten Schnittstelle zwischen einem eingebetteten Speicher (3), programmierbaren Logikblöcken (1) und Eingabe-Ausgabe-Ressourcen (2), wobei die feldprogrammierbare Gatteranordnung Folgendes umfasst:
eine Anordnung von programmierbaren Logikblöcken (1);
eine Vielzahl von Eingabe-Ausgabe-Ressourcen (2);
mindestens einen eingebetteten Speicher (3), an den Eingangs- und Ausgangspins, eine Vielzahl von Adressleitungen, Datenleitungen und Steuerleitungen angeschlossen sind;
ein Mehrzweck-Routing-Architektur (1a), die Routing-Leitungen umfasst, auf die die programmierbaren Logikblöcke und die Eingabe-Ausgabe-Ressourcen zugegreifen können; wobei
die Schnittstelle dafür ausgelegt ist, die programmierbaren Logikblöcke und Eingabe-Ausgabe-Ressourcen mit Hilfe mehrerer dedizierter direkter Verbindungen mit dem eingebetteten Speicher zu verbinden, wobei die mehreren direkten Verbindungen von der Mehrzweck-Routing-Architektur (4, 3i, 3o, A₀, A₇, D₀, D₇) verschieden sind und nicht Teil derselben sind.
wobei die Mehrzweck-Routing-Architektur (1a) von den Adressleitungen, Datenleitungen und Steuerleitungen des mindestens einen eingebetteten Speichers (3) isoliert ist;
wobei die direkten Verbindungen mit den Eingangspins des eingebetteten Speichers (3) verbunden sind und von Ausgängen der programmierbaren Logikblöcke (1) in der Nähe des eingebetteten Speichers (3) abgegriffen werden und die Ausgangspins des eingebetteten Speichers (3) direkt mit den Eingängen der programmierbaren Logikblöcke (1) in der Nähe des eingebetteten Speichers (3) verbunden sind; **dadurch gekennzeichnet, dass**
die programmierbaren Logikblöcke (1) Speicherregister oder Flip-Flops umfassen, die zum Speichern von Signalen konfiguriert sind, die von dem eingebetteten Speicher (3) durch die direkten Verbindungen gesendet oder empfangen werden, wobei Register im eingebetteten Speicher (3) eliminiert werden, wodurch eine erhebliche Chipfläche eingespart wird.

2. Feldprogrammierbare Gatteranordnung nach Anspruch 1, wobei der eingebettete Speicher jeweils an seinen Eingangs- und Ausgangsspins eine Vielzahl von Multiplexern und Demultiplexern aufweist.

3. Feldprogrammierbare Gatteranordnung nach Anspruch 2, wobei
die Eingänge in den Multiplexer Ausgänge von verschiedenen der programmierbaren Logikblöcke oder sogar des gleichen programmierbaren Logikblocks oder von den Eingabe-Ausgabe-Ressourcen sind;
die Ausgänge des Demultiplexers mit den Eingängen oder Eingangs-Ausgangs-Ressourcen der programmierbaren Logikblöcke verbunden sind.

4. Feldprogrammierbare Gatteranordnung nach einem der vorhergehenden Ansprüche, wobei die programmierbaren Logikblöcke nur durch programmierbare Anzapfungen zu/von deren Ein- und Ausgängen mit dem eingebetteten Speicher interagieren.

5. Feldprogrammierbare Gatteranordnung nach einem der vorhergehenden Ansprüche, die des Weiteren ein dediziertes Bus-basiertes Routing zum Zusammenlegen der Daten- und Adressleitungen umfasst, um eine Vielzahl von eingebetteten Speichern zu größeren Speichern zu kombinieren.

6. Feldprogrammierbare Gatteranordnung nach einem der vorhergehenden Ansprüche, wobei die Speicherregister oder Flip-Flops der programmierbaren Logikblöcke auch Eingaben von der Mehrzweck-Routing-Architektur empfangen können.

7. Feldprogrammierbare Gatteranordnung nach einem der vorhergehenden Ansprüche, wobei die programmierbaren Logikblöcke jeweils eine LUT umfassen, wobei die LUT und das Speicherregister jedes programmierbaren Logikblocks unabhängig von der Schnittstelle zum eingebetteten Speicher auch für andere Funktionen verwendet werden können.

8. Feldprogrammierbare Gatteranordnung nach Anspruch 6, wobei die Speicherregister oder Flip-Flops selektiv umgangen werden für den Fall, dass nicht registrierte Speichereingänge und -ausgänge benötigt werden.

9. Feldprogrammierbare Gatteranordnung nach einem der vorhergehenden Ansprüche, wobei der eingebettete Speicher entweder ein ROM oder RAM ist.

10. Feldprogrammierbare Gatteranordnung nach einem der vorhergehenden Ansprüche, wobei die Konnektivität der programmierbaren Logikblöcke und Eingabe-Ausgabe-Ressourcen mit der Mehrzweck-Routing-Architektur zusammen mit der Schnittstelle und dem eingebetteten Speicher existiert.

## Revendications

1. Réseau de portes programmable, comportant une interface simplifiée entre une mémoire intégrée (3) et des blocs logiques programmables (1) et des ressources d'entrée-sortie (2), le réseau de portes programmable comprenant :
un réseau de blocs logiques programmables (1) ;
une pluralité de ressources d'entrée-sortie (2) ;
au moins une mémoire intégrée (3) comportant des broches d'entrée et des broches de sortie et une pluralité de lignes d'adresse, de lignes de données et de lignes de commande connectées à celles-ci ;
une architecture d'acheminement polyvalente (1a) comprenant des lignes d'acheminement, conçue pour un accès par les blocs logiques programmables et les ressources d'entrée-sortie ;
dans lequel ladite interface est agencée pour la connexion desdits blocs logiques programmables et desdites ressources d'entrée-sortie à la mémoire intégrée en utilisant de multiples interconnexions directes dédiées, lesdites multiples interconnexions directes étant distinctes de et ne faisant pas partie de l'architecture d'acheminement polyvalente (4, 3i, 3o, Ao, A₇, Do, D₇) ;
l'architecture d'acheminement polyvalente (la) étant ainsi isolée des lignes d'adresse, des lignes de données et des lignes de commande de ladite au moins une mémoire intégrée (3) ;
dans lequel les interconnexions directes sont connectées aux broches d'entrée de la mémoire intégrée (3) et proviennent de sorties de blocs logiques programmables (1) à proximité de la mémoire intégrée (3) et les broches de sortie de la mémoire intégrée (3) sont directement connectées à des entrées de blocs logiques programmables (1) dans le voisinage de la mémoire intégrée (3) ; **caractérisé en ce que** lesdits blocs logiques programmables (1) comprennent des registres de mémoire ou registres bistables qui sont configurés pour le verrouillage de signaux qui doivent être envoyés à ou reçus de la mémoire intégrée (3) par l'intermédiaire desdites interconnexions directes, les registres internes de ladite mémoire intégrée (3) étant ainsi éliminés, ce qui permet d'économiser un espace significatif sur les puces.

2. Réseau de portes programmable selon la revendication 1, dans lequel ladite mémoire intégrée comporte une pluralité de multiplexeurs et de démultiplexeurs au niveau de ses broches d'entrée et de ses broches de sortie respectivement.

3. Réseau de portes programmable selon la revendication 2, dans lequel
les entrées d'accès au multiplexeur sont des sorties de divers blocs logiques programmables parmi lesdits blocs logiques programmables, voire du même bloc logique programmable ou des ressources d'entrée-sortie ;
les sorties du démultiplexeur sont connectées à des entrées des blocs logiques programmables ou à des ressources d'entrée-sortie.

4. Réseau de portes programmable selon l'une quelconque des revendications précédentes, dans lequel les blocs logiques programmables interagissent avec ladite mémoire intégrée exclusivement par l'intermédiaire de connexions programmables vers/à partir de leurs entrées et sorties.

5. Réseau de portes programmable selon l'une quelconque des revendications précédentes, comprenant en outre un acheminement par bus dédié pour réunir les lignes d'adresse et les lignes de données, afin de combiner une pluralité de mémoires intégrées en des mémoires plus vastes.

6. Réseau de portes programmable selon l'une quelconque des revendications précédentes, dans lequel lesdits registres de mémoire ou registres bistables desdits blocs logiques programmables peuvent aussi recevoir des entrées en provenance de l'architecture d'acheminement polyvalente.

7. Réseau de portes programmable selon l'une quelconque des revendications précédentes, dans lequel lesdits blocs logiques programmables comprennent chacun un LUT, le LUT et le registre de mémoire de chaque bloc logique programmable pouvant aussi être utilisés pour une autre fonctionnalité indépendante de l'interfaçage à la mémoire intégrée.

8. Réseau de portes programmable selon la revendication 6, dans lequel lesdits registres de mémoire ou registres bistables sont contournés sélectivement dans le cas où des entrées et sorties en mémoire sans enregistrement sont nécessaires.

9. Réseau de portes programmable selon l'une quelconque des revendications précédentes, dans lequel ladite mémoire intégrée est soit une mémoire morte, soit une mémoire vive.

10. Réseau de portes programmable selon l'une quelconque des revendications précédentes, dans lequel la connectivité desdits blocs logiques programmables et des ressources d'entrée-sortie avec l'architecture d'acheminement polyvalente coexiste avec ladite interface et avec ladite mémoire intégrée.
